# EUROPÄISCHE PATENTSCHRIFT

(11) **EP 2 895 348 B1**
(45) Veröffentlichungstag und Bekanntmachung des Hinweises auf die Patenterteilung: **12.04.2017**
(21) Anmeldenummer: 13747974.7
(22) Anmeldetag: 02.08.2013
(51) Int. Cl.: H01H 19/00, H03K 17/96, H03K 17/965, B60K 37/06, G05G 1/08, G05G 5/03

(54) **BEDIENVORRICHTUNG FÜR EINE FUNKTIONSEINRICHTUNG EINES KRAFTFAHRZEUGS**
MULTIFUNCTION CONTROL DEVICE FOR FUNCTIONAL DEVICE IN THE VEHICLE
DISPOSITIF DE COMMANDE POUR UN DISPOSITIF FONCTIONNEL DU VÉHICULE

(30) Priorität: 14.09.2012 DE 102012018291
(43) Veröffentlichungstag der Anmeldung: 22.07.2015
(73) Patentinhaber: Audi AG, 85045 Ingolstadt (DE)
(72) Erfinder: BOUAZIZ, Tahar, 85055 Ingolstadt (DE)
(74) Vertreter: Brandt, Kai
(86) Internationale Anmeldenummer: PCT/EP2013/002315
(87) Internationale Veröffentlichungsnummer: WO 2014/040671

(56) Entgegenhaltungen:
- WO-A1-02/088864
- WO-A1-2011/033193
- DE-A1-102008 057 098
- DE-A1-102010 010 574
- US-B1- 6 636 197

## Beschreibung

Die vorliegende Erfindung betrifft eine Bedienvorrichtung für eine Funktionseinrichtung eines Kraftfahrzeugs. Überdies betrifft die vorliegende Erfindung ein Kraftfahrzeug. Schließlich betrifft die vorliegende Erfindung ein Verfahren zum Bedienen einer Funktionseinrichtung eines Kraftfahrzeugs mit einer Bedienvorrichtung.

Zur Bedienung von Funktionseinrichtungen eines Kraftfahrzeugs sind entsprechende Bedienvorrichtungen vorgesehen. Diese können einen Drehsteller oder Drehencoder umfassen. Heutige Drehsteller besitzen mechanische Raststellungen in denen sie entlang ihrer Drehrichtung einrasten. Diese Rastpositionen werden vom Nutzer bzw. der Bedienperson haptisch wahrgenommen. Oft wird auch zusätzlich ein akustisches Signal, beispielsweise ein Klicken, ausgegeben. Diese Art von Drehsteller ist weit verbreitet und kommt beispielsweise in Klimabedienteilen oder der zentralen Eingabeeinheit im Kraftfahrzeug zum Einsatz. In der Regel werden die Drehsteller zur Weiterschaltung einer diskreten Funktion genutzt. Beispielsweise wird in einem Klimabedienteil die Temperatur pro Raststufe um eine vorgegebene Temperatur erhöht oder die Geschwindigkeit eines Lüfters wird hochgesetzt.

In grafisch basierten Systemen, wie einer Mensch-Maschine-Schnittstelle, kann der Drehsteller zur Navigation im Display der Mensch-Maschine-Schnittstelle genutzt werden. Dabei bewirkt eine Verstellung des Drehstellers um eine Rastposition eine Verschiebung der Bildschirmdarstellung um einen Schritt nach oben oder nach unten. Bei einem Navigationssystem kann durch die Verstellung des Drehstellers um eine Rastposition eine Vergrößerung bzw. eine Verkleinerung der Kartendarstellung um eine Stufe bewirkt werden.

Die Raststellungen des Drehstellers werden in der Regel mechanisch mit einer Rastkurve oder magnetisch mit Magnetpolpaaren erzeugt. Mit jeder Raststellung wird ein entsprechender elektrischer Wert ausgegeben. D. h. beim Drehen in die nächste Raststellung wird ein elektrisches Signal von einer Steuereinrichtung ausgewertet, um die Drehrichtung und die Anzahl der Raststufen bzw. Klicks zu ermitteln. Dieses Signal ist konform mit den haptisch spürbaren Raststufen, in denen der Drehsteller einrastet bzw. nach dem Drehen stabil stehen bleibt.

Typischerweise haben die Drehsteller um die Nulllage der jeweiligen Rastposition ein mechanisches Spiel. Manche Drehsteller rasten nach dem Loslassen an einer bestimmten Position zwischen zwei Raststufen nicht automatisch in eine der Raststufen ein und bleiben zwischen den Raststufen stehen. Dies kann zu fehlerhaften Bediensignalen für die jeweilige Funktionseinrichtung des Kraftfahrzeugs führen. Beispielsweise kann bei der Bedienung einer Liste das Zeigerelement nach dem Loslassen des Drehstellers zwischen zwei Listeneinträgen stehen bleiben.

In diesem Zusammenhang offenbart die DE 196 09 390 A1 eine Bedienvorrichtung mit mehreren Stellgliedern zur Bedienung verschiedener Geräte in einem Kraftfahrzeug. Die Stellglieder weisen jeweils ein auf eine Berührung ansprechendes Sensorelement auf.

Die DE 10 2004 006 605 A1 beschreibt eine Bedienvorrichtung zur Bedienung eines Kraftfahrzeugs. Dabei weist ein Bedienelement der Bedienvorrichtung einen Berührungssensor zur Erkennung einer Berührung des Bedienelements auf.

Darüber hinaus beschreibt die DE 10 2007 024 292 A1 ein Drehbedienelement für eine Fahrzeugklimaanlage. Das Drehbedienelement weist eine Sensoreinheit zur Erkennung eines Verdrehens des Drehbedienelements auf. In Abhängigkeit von der Verdrehung des Drehbedienelements wird ein akustisches Signal in Form von Rastgeräuschen ausgegeben.

Die DE 10 2009 006 448 A1 beschreibt ein Verfahren zum Bestimmen einer Sitzposition eines Insassen in einem Fahrzeug aufgrund einer Betätigung eines Bedienelements des Fahrzeugs. In Abhängigkeit von der erfassten Sitzposition werden Funktionseinrichtungen in dem Fahrzeug für den Fahrer oder den Beifahrer eingestellt. Dazu weist das Bedienelement einen kapazitiven Sensor auf, mit dem erfasst werden kann, ob eine Annäherung eines Körperteils von der Fahrerseite oder der Beifahrerseite erfolgt.

Zudem ist aus der DE 10 2010 010 574 A1 ein Drehsteller für ein Fahrzeug bekannt, der eine berührungssensitive Oberfläche aufweist. Durch das Auswerten der Signale der berührungssensitiven Oberfläche kann eine Berührung und Betätigung des Drehstellers zur Steuerung von Funktionen genutzt werden.

Des Weiteren beschreibt die US 6 636 197 B1 eine Bedienvorrichtung, die als Drehsteller ausgebildet ist. Mit der Bedienvorrichtung kann einem Bediener eine haptische Rückmeldung ausgegeben werden. Zudem ist ein Totmann-Schalter vorgeschlagen, der einen Kontakt bzw. eine Berührung durch eine Person erfasst.

Schließlich beschreibt die DE 10 2008 057 098 A1 einen Drehsteller für ein Fahrzeug, der eine Rastung und eine Bewegungserfassung aufweist. Mit einer Sensoreinrichtung des Drehstellers kann die Drehrichtung und der Drehwinkel eines Stellelements erfasst werden.

Es ist Aufgabe der vorliegenden Erfindung, eine Bedienvorrichtung der eingangs genannten Art bereitzustellen, die einfacher und zuverlässiger bedient werden kann.

Diese Aufgabe wird durch eine Bedienvorrichtung mit den Merkmalen des Patentanspruchs 1 und durch ein Kraftfahrzeug mit den Merkmalen des Patentanspruchs 3 gelöst. In gleicher Weise wird diese Aufgabe durch ein Verfahren mit den Merkmalen des Patentanspruchs 4 gelöst. Vorteilhafte Weiterbildungen der vorliegenden Erfindung sind in den Unteransprüchen angegeben.

Die erfindungsgemäße Bedienvorrichtung für eine Funktionseinrichtung eines Kraftfahrzeugs umfasst einen Drehsteller, der an einem Halteelement drehbar gelagert ist und der zumindest ein Kodierelement aufweist, eine Erfassungseinrichtung zum Erfassen eines absoluten Drehwinkels zwischen dem Drehsteller und dem Halteelement anhand einer Kodierung des zumindest einen Kodierelements und eine Rasteinrichtung, durch die dem Drehsteller entlang einer Drehrichtung eine Mehrzahl von Rastpositionen vorgegeben sind, wobei die Erfassungseinrichtung dazu ausgebildet ist, anhand der Kodierung des zumindest einen Kodierelements die jeweilige Rastposition und den absoluten Drehwinkel zwischen zumindest zwei der Rastpositionen zu erfassen, und wobei die Bedienvorrichtung ein Sensoreinrichtung zum Erfassen einer Berührung des Drehstellers umfasst.

Die Bedienvorrichtung kann im Armaturenbrett oder in der Mittelkonsole des Kraftfahrzeugs angeordnet sein. Das Kraftfahrzeug kann auch mehrere Bedienvorrichtungen umfassen, mit denen Funktionseinrichtungen, wie z. B. eine Klimaanlage, ein Navigationssystem, eine Bedieneinrichtung mit dazugehöriger Anzeige, ein Unterhaltungssystem oder dergleichen, angesteuert werden können. Die Bedienvorrichtung umfasst einen Drehsteller, der auch als Dreh-/Drücksteller ausgebildet sein kann. Darüber hinaus umfasst die Bedienvorrichtung eine Rasteinrichtung, die dem Drehsteller mehrere Raststufen bzw. Rastpositionen vorgibt. Diese Rastpositionen können mechanisch mit einer Rastkurve oder durch entsprechende Magnete erzeugt werden. Bei einer Drehung des Drehstellers rastet dieser in den Rastpositionen ein.

An dem Drehsteller ist zumindest ein Kodierelement angeordnet. Das zumindest ein Kodierelement erstreckt sich bevorzugt entlang der Umfangsrichtung des Drehstellers oder einer Welle des Drehstellers. Zudem umfasst die Bedienvorrichtung eine Erfassungseinrichtung, die einen Sensor umfassen kann. Des Weiteren kann die Erfassungseinrichtung ortsfest an dem Halteelement oder einem Gehäuse der Bedienvorrichtung angeordnet sein. Durch die Kodierung des zumindest einen Kodierelements wird in der Erfassungseinrichtung ein entsprechendes Ausgangsignal erzeugt. Dieses Kodierelement kann beispielsweise einen oder mehrere Magnete umfassen und die Erfassungseinrichtung kann einen magnetischen Sensor, beispielsweisen einen Hall-Sensor umfassen. Alternativ dazu kann das Kodierelement Aussparungen oder eine vorbestimmte Geometrie aufweisen, die mit einem optischen Sensor der Erfassungseinrichtung abgetastet werden. Ebenso ist die Verwendung von Schleifkontakten denkbar.

Die Erfassungseinrichtung der Bedienvorrichtung ist nun dazu ausgebildet, anhand der Kodierung des zumindest einen Kodierelements die vorgegebenen Rastpositionen einzeln zu erfassen. Damit müssen die Raststufen nicht mehr einzelnen elektronisch ausgewertet werden. Zudem kann mit der Erfassungseinrichtung der absolute Drehwinkel zwischen mindestens zwei Rastpositionen erfasst werden. Zudem kann mit der Erfassungseinrichtung anhand der Kodierung des zumindest einen Kodierelements die Drehrichtung des Drehstellers erfasst werden. Bei der Bedienvorrichtung sind die diskreten Rastpositionen vorhanden, die durch die haptische Rückmeldung beim Benutzer ein hochwertiges Bediengefühl hervorrufen. Darüber hinaus können leichte Auslenkungen des Drehstellers vor dem Einrasten in die nächste Rastposition mit der Erfassungseinrichtung erkannt werden. Dadurch können auf einfache Weise neben den Rastpositionen auch die Zwischenstellungen zwischen den Raststufen mit einer hohen Auflösung erfasst werden und entsprechend weiter verarbeitet werden.

Zudem umfasst die Bedienvorrichtung eine Sensoreinrichtung, mit der eine Berührung des Drehstellers erfasst wird. Somit kann berücksichtigt werden, ob eine Bedienperson die Bedienvorrichtung momentan bedient oder nicht. Damit kann eine Bedienung der Bedienvorrichtung zuverlässiger erfasst werden.

Ferner umfasst die Bedienvorrichtung eine Steuereinrichtung, die mit der Erfassungseinrichtung und der Sensoreinrichtung gekoppelt ist und die in Abhängigkeit von der erfassten Rastposition, des erfassten absoluten Drehwinkels zwischen den zumindest zwei Rastpositionen und/oder der erfassten Berührung des Drehstellers ein Steuersignal zum Bedienen der Funktionseinrichtung ausgibt. Somit können neben den diskreten Raststellungen auch die Zwischenstellungen des Drehstellers zwischen den Rastpositionen herangezogen werden, um eine Funktionseinrichtung des Kraftfahrzeugs anzusteuern. Darüber hinaus kann berücksichtigt werden, ob der Benutzer den Drehsteller berührt oder nicht. Hierbei kann auch die zeitliche Dauer einer Berührung des Drehstellers berücksichtigt werden. Alternativ oder zusätzlich kann die Berührung des Drehstellers an unterschiedlichen Bereichen des Drehstellers erfasst werden. Dazu kann die Sensoreinrichtung mehrere Einzelsensoren umfassen, die an der Außenfläche des Drehstellers verteilt angeordnet sind. Damit kann eine ungewollte Bedienung des Drehstellers besser erfasst werden.

Zudem gibt die Steuereinrichtung ein jeweiliges Raststeuersignal für jede der erfassten Rastpositionen aus.

Ferner gibt die Steuereinrichtung zumindest ein Zwischensteuersignal in Abhängigkeit von dem erfassten absoluten Drehwinkel zwischen den zumindest zwei Rastpositionen aus. Wenn sich der Drehsteller zwischen zwei Raststufen befindet, kann je nach Drehwinkel ein entsprechendes Zwischensteuersignal als das Steuersignal ausgegeben werden. Zwischen den Raststufen kann auch eine Mehrzahl von Zwischenstufen vorgesehen sein, wobei jeder Zwischenstufe ein Zwischensteuersignal zugeordnet ist. Damit kann auch bei einer Stellung oder einer Bewegung des Drehstellers zwischen zwei diskreten Rastpositionen eine Steuerung der Funktionseinrichtung des Kraftfahrzeugs ermöglicht werden.

Des Weiteren gibt die Steuereinrichtung ein Raststeuersignal unabhängig davon aus, ob die Sensoreinrichtung eine Berührung des Drehstellers erfasst. Wenn der Drehsteller in eine vorgegebene Rastposition einrastet, befindet er sich in einem definierten Betriebszustand. In diesem Fall kann ein entsprechendes Steuersignal ausgegeben werden, wenn der Bediener den Drehsteller momentan berührt oder wenn der Bediener den Drehsteller nicht (mehr) berührt.

Des Weiteren gibt die Steuereinrichtung ein Zwischensteuersignal nur aus, wenn die Sensoreinrichtung eine Berührung des Drehstellers erfasst. Wenn der Bediener den Drehsteller momentan nicht bedient und sich der Drehsteller zwischen zwei Rastpositionen befindet, kann dem Drehsteller nicht zuverlässig ein Betriebszustand zugeordnet werden. Daher wird in einer Zwischenposition zwischen zwei der Raststellung nur dann ein Steuersignal ausgegeben wenn der Benutzer den Drehsteller berührt bzw. diesen momentan bedient. Somit kann eine zuverlässige Bedienung ermöglicht werden.

Zudem erfasst die Steuereinrichtung anhand des erfassten absoluten Drehwinkels die nächstliegende der Rastpositionen und gibt das Raststeuersignal für die nächstliegende der Rastpositionen aus, falls die Sensoreinrichtung keine Berührung des Drehstellers erfasst. Wenn der Bediener den Drehsteller momentan nicht bedient, kann die Steuereinrichtung die der momentanen Stellung des Drehsteller am nächsten liegende Rastposition ermitteln und das Rastsignal und ein derartiges Steuersignal ausgeben, als ob sich der Drehsteller in dieser Rastposition befinden würde. Alternativ zur Position des Drehstellers kann auch die Drehgeschwindigkeit oder einen Änderung der Drehgeschwindigkeit herangezogen werden, um ein Rastposition zu ermitteln, wenn der Drehsteller momentan nicht berührt wird. Beispielsweise kann für die Drehgeschwindigkeit und/oder die Änderung der Drehgeschwindigkeit ein Schwellwert vorgegeben werden. Wenn dieser Schwellwert überschritten wird, kann davon ausgegangen werden, dass der Bediener den Drehsteller in die in Drehrichtung nachfolgende Rastposition drehen wollte bzw. möchte, auch wenn sich der Drehsteller nach dem loslassen näher an der in Drehrichtung zurückliegenden Rastposition befindet. Damit kann eine zuverlässige Bedienung mit der Bedienvorrichtung ermöglicht werden.

In einer weiteren Ausgestaltung umfasst die Sensoreinrichtung einen optischen Sensor und/oder einen kapazitiven Sensor. Die Sensoreinrichtung kann auch mehrere dieser Sensoren umfassen, die an der Außenfläche des Drehstellers angeordnet sind. Damit kann eine Berührung des Drehstellers zuverlässig erfasst werden und die Funktionseinrichtung bedient werden.

Das erfindungsgemäße Kraftfahrzeug umfasst die zuvor beschriebene Bedienvorrichtung.

Schließlich wird erfindungsgemäß bereitgestellt ein Verfahren zum Bedienen einer Funktionseinrichtung eines Kraftfahrzeugs mit einer Bedienvorrichtung, wobei die Bedienvorrichtung einen Drehsteller, der an einem Halteelement drehbar gelagert ist und der zumindest ein Kodierelement aufweist, umfasst, durch Erfassen eines absoluten Drehwinkels zwischen dem Drehsteller und dem Halteelement anhand einer Kodierung des zumindest einen Kodierelements, Vorgeben einer Mehrzahl von Rastpositionen für den Drehsteller entlang seiner Drehrichtung, Erfassen der jeweiligen Rastposition und des absoluten Drehwinkels zwischen zumindest zwei der Rastpositionen anhand der Kodierung des zumindest einen Kodierelements und Erfassen einer Berührung des Drehstellers mittels seiner Sensoreinrichtung, Ausgeben eines Steuersignals zum Bedienen der Funktionseinrichtung in Abhängigkeit von der erfassten Rastposition, des erfassten absoluten Drehwinkels zwischen den zumindest zwei Rastpositionen und/oder der erfassten Berührung des Drehstellers, Ausgeben eines jeweiligen Raststeuersignals für jede der erfassten Rastpositionen, Ausgeben eines Zwischensteuersignals in Abhängigkeit von dem erfassten absoluten Drehwinkel zwischen den zumindest zwei Rastpositionen, Ausgeben des Raststeuersignals unabhängig davon, ob die Sensoreinrichtung eine Berührung des Drehstellers erfasst, Ausgeben des Zwischensteuersignals nur, wenn die Sensoreinrichtung eine Berührung des Drehstellers erfasst und Erfassen der nächstliegenden der Rastpositionen anhand des erfassten absoluten Drehwinkels und Ausgeben des Raststeuersignals für die nächstliegende der Rastpositionen, falls die Sensoreinrichtung keine Berührung des Drehstellers erfasst.

Die zuvor im Zusammenhang mit der erfindungsgemäßen Bedienvorrichtung beschriebenen Vorteile und Weiterbildungen gelten in gleicher Weise für das erfindungsgemäße Kraftfahrzeug und das erfindungsgemäße Verfahren.

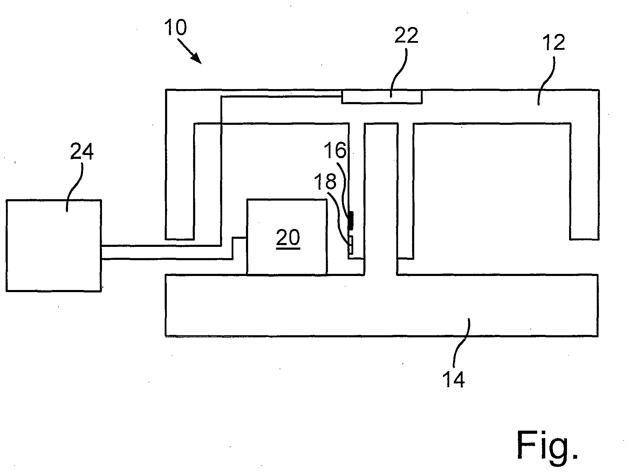

Die vorliegende Erfindung wird nun anhand der beigefügten Zeichnung näher erläutert. Dabei zeigt die einzige Figur eine schematische Darstellung einer Bedienvorrichtung in einer geschnittenen Seitenansicht.

Das nachfolgend näher geschilderte Ausführungsbeispiel stellt eine bevorzugte Ausführungsform der vorliegenden Erfindung dar.

Die Figur zeigt eine schematische Darstellung einer Bedienvorrichtung 10 in einer geschnittenen Seitenansicht. Die Bedienvorrichtung 10 dient zum Bedienen einer Funktionseinrichtung eines Kraftfahrzeugs. Eine solche Funktionseinrichtung kann eine Klimaanlage, ein Navigationssystem, eine Bedieneinrichtung mit dazugehöriger Anzeige, ein Unterhaltungssystem oder dergleichen sein. Die Bedienvorrichtung 10 umfasst einen Drehsteller 12, der an einem Halteelement 14 drehbar gelagert ist. Des Weiteren sind an dem Drehsteller 12 zwei Kodierelemente 16 und 18 angeordnet. Die Kodierelemente 16, 18 können einen oder mehrere Magnete umfassen. Alternativ dazu können die Kodierelemente 16, 18 elektrische Kontakte umfassen. In einer weiteren Ausführungsform können die Kodierelemente 16, 18 entsprechende Aussparungen umfassen.

Des Weiteren umfasst die Bedienvorrichtung 10 eine Erfassungseinrichtung 20, die mechanisch fest mit dem Halteelement 14 verbunden ist. Die Erfassungseinrichtung 20 kann ein entsprechendes Sensorelement umfassen, das mit den Kodierelementen 16, 18 so zusammenwirkt, dass von der Erfassungseinrichtung 20 in Abhängigkeit von einer Kodierung der Kodierelemente 16, 18 jeweils ein Ausgangssignal bereitgestellt wird. Wenn die Kodierelemente 16, 18 Magnete umfassen, kann die Erfassungseinrichtung 20 einen magnetischen Sensor, beispielsweise einen Hall-Sensor aufweisen. Weisen die Kodierelemente 16, 18 elektrische Kontakte auf, kann die Erfassungseinrichtung 20 Schleifkontakte umfassen. Sind die Kodierelemente 16, 18 durch Aussparungen gebildet, kann die Erfassungseinrichtung 20 einen optischen Sensor umfassen. Die Bedienvorrichtung 10 weist zusätzlich eine hier nicht dargestellte Rasteinrichtung auf, durch die dem Drehsteller 12 Rastpositionen vorgegeben sind.

Durch die Drehung des Drehstellers 12 werden durch die beiden Kodierelemente 16 und 18 in der Erfassungseinrichtung 20 zumindest zwei Ausgangssignale erzeugt. Dabei können die Kodierelemente 16, 18 derart ausgebildet sein, dass sich zwei Ausgangsignale ergeben, die einen im Wesentlichen kontinuierlichen bzw. analogen Verlauf aufweisen. Die Ausgangssignale können auch entlang der Drehrichtung versetzt zueinander sein. Zur Auswertung dieser analogen Ausgangssignale kann jeweils ein Schwellwert vorgebeben werden. In Abhängigkeit von dem Überschreiten oder Unterschreiten des Schwellwerts kann die Drehrichtung und die einzelnen Rastposition ermittelt werden. Des Weiteren kann anhand der Ausgangssignale der Drehwinkel zwischen zumindest zwei Rastpositionen ermittelt werden. Um den Drehwinkel in einem Bereich zwischen zumindest zwei Rastpositionen zu ermitteln, wird die jeweilige Amplitude des Ausgangssignals herangezogen.

Es können auch drei Kodierelemente 16, 18 verwendet werden, wobei die Kodierelemente 16, 18 dabei derart ausgestaltet sein können, dass die Erfassungseinrichtung 20 durch das Erfassen von zwei der drei Kodierelement 16, 18 jeweils ein digitales Ausgangssignal ausgibt. Anhand der digitalen Ausgangssignale kann die Drehrichtung und die einzelnen ermittelt werden. Durch Auswertung des dritten der drei Kodierelemente 16, 18 wird von der Erfassungseinrichtung 20 ein Ausgangssignal ausgegeben, das einen kontinuierlichen bzw. analogen Verlauf aufweist. Anhand des Ausgangssignals kann der Drehwinkel zwischen zwei der Rastpositionen ermittelt werden.

Des Weiteren umfasst die Bedienvorrichtung 10 eine Sensoreinrichtung 22, mit der eine Berührung des Drehstellers 12 erfasst werden kann. Dazu kann die Sensoreinrichtung 22 einen oder mehrere Sensoren umfassen, die entlang der Außenfläche des Drehstellers 12 angeordnet sind. Diese Sensoreinrichtung 22 kann kapazitive und/oder optische Sensoren umfassen. Zudem umfasst die Bedienvorrichtung 10 eine Steuereinrichtung 24, die mit der Erfassungseinrichtung 20 und der Sensoreinrichtung 22 gekoppelt ist. Die Steuereinrichtung 24 ist mit der hier nicht dargestellten Funktionseinrichtung des Kraftfahrzeugs gekoppelt und kann an diese entsprechende Steuersignale übermitteln. Diese Steuersignale werden in Abhängigkeit von den Signalen der Erfassungseinrichtung 20 und der Sensoreinrichtung 22 berechnet.

Wenn sich der Drehsteller 12 in einer vorgegebenen Rastposition befindet, wir von der Steuereinrichtung ein Raststeuersignal erzeugt. Dieses Signal wird unabhängig davon erzeugt, ob mit der Sensoreinrichtung 22 eine Berührung des Drehstellers 12 erfasst wird oder nicht. Wenn sich der Drehsteller 12 in einem Bereich zwischen zwei Raststellungen befindet, wird mit der Steuereinrichtung 24 ein Zwischensteuersignal ausgegeben. Dieses Zwischensteuersignal wird allerdings nur ausgegeben, wenn mit der Sensoreinrichtung 22 ein Berühren des Drehstellers 12 erfasst wird.

Die Steuereinrichtung 24 ist dazu ausgebildet, für den Fall, dass mit der Sensoreinrichtung 22 keine Berührung des Drehstellers 12 erfasst wird und sich der Drehsteller 12 zwischen zwei der Rastpositionen befindet, die dem Drehsteller 12 nächstliegende Rastposition zu ermitteln. Wenn sich der Drehsteller 12 zwischen zwei Rastpositionen nicht berührt wird, wird mit der Steuereinrichtung 24 das Raststeuersignal ausgegeben, dass der nächstliegenden Rastposition zugeordnet ist. Damit kann eine zuverlässige Bedienung der Bedienvorrichtung 10 ermöglicht werden.

## Patentansprüche

1. Bedienvorrichtung (10) für eine Funktionseinrichtung eines Kraftfahrzeugs mit
- einem Drehsteller (12), der an einem Halteelement (14) drehbar gelagert ist und der zumindest ein Kodierelement (16, 18) aufweist,
- einer Erfassungseinrichtung (20) zum Erfassen eines absoluten Drehwinkels zwischen dem Drehsteller (12) und dem Halteelement (14) anhand einer Kodierung des zumindest einen Kodierelements (16, 18) und
- einer Rasteinrichtung, durch die dem Drehsteller (12) entlang einer Drehrichtung eine Mehrzahl von Rastpositionen vorgegeben sind, wobei
- die Erfassungseinrichtung (20) dazu ausgebildet ist, anhand der Kodierung des zumindest einen Kodierelements (16, 18) die jeweilige Rastposition und den absoluten Drehwinkel zwischen zumindest zwei der Rastpositionen zu erfassen, und
- die Bedienvorrichtung (10) eine Sensoreinrichtung (22) zum Erfassen einer Berührung des Drehstellers (12) umfasst, und
- einer Steuereinrichtung (24), die mit der Erfassungseinrichtung (20) und der Sensoreinrichtung (22) gekoppelt ist und die in Abhängigkeit von der erfassten Rastposition, des erfassten absoluten Drehwinkels zwischen den zumindest zwei Rastpositionen und/oder der erfassten Berührung des Drehstellers (12) ein Steuersignal zum Bedienen der Funktionseinrichtung ausgibt, wobei
- die Steuereinrichtung (24) ein jeweiliges Raststeuersignal für jede der erfassten Rastpositionen ausgibt und
- die Steuereinrichtung (24) zumindest ein Zwischensteuersignal in Abhängigkeit von dem erfassten absoluten Drehwinkel zwischen den zumindest zwei Rastpositionen ausgibt,
**dadurch gekennzeichnet, dass**
- die Steuereinrichtung (24) ein Raststeuersignal unabhängig davon ausgibt, ob die Sensoreinrichtung (22) eine Berührung des Drehstellers (12) erfasst,
- die Steuereinrichtung (24) ein Zwischensteuersignal nur ausgibt, wenn die Sensoreinrichtung (22) eine Berührung des Drehstellers (12) erfasst und
- die Steuereinrichtung (24) anhand des erfassten absoluten Drehwinkels die nächstliegende der Rastpositionen erfasst und das Raststeuersignal für die nächstliegende der Rastpositionen ausgibt, falls die Sensoreinrichtung (22) keine Berührung des Drehstellers (12) erfasst.

2. Bedienvorrichtung (10) nach Anspruch 1,
**dadurch gekennzeichnet, dass**
die Sensoreinrichtung (22) einen optischen Sensor und/oder einen kapazitiven Sensor umfasst.

3. Kraftfahrzeug mit einer Bedienvorrichtung (10) nach einem der vorhergehenden Ansprüche.

4. Verfahren zum Bedienen einer Funktionseinrichtung eines Kraftfahrzeugs mit einer Bedienvorrichtung, wobei die Bedienvorrichtung einen Drehsteller (12), der an einem Halteelement (14) drehbar gelagert ist und der zumindest ein Kodierelement (16, 18) aufweist, umfasst, durch
- Erfassen eines absoluten Drehwinkels zwischen dem Drehsteller (12) und dem Halteelement (14) anhand einer Kodierung des zumindest einen Kodierelements (16, 18),
- Vorgeben einer Mehrzahl von Rastpositionen für den Drehsteller (12) entlang seiner Drehrichtung,
- Erfassen der jeweiligen Rastposition und des absoluten Drehwinkels zwischen zumindest zwei der Rastpositionen anhand der Kodierung des zumindest einen Kodierelements (16, 18),
- Erfassen einer Berührung des Drehstellers (12) mittels einer Sensoreinrichtung (22),
- Ausgeben eines Steuersignals zum Bedienen der Funktionseinrichtung in Abhängigkeit von der erfassten Rastposition, des erfassten absoluten Drehwinkels zwischen den zumindest zwei Rastpositionen und/oder der erfassten Berührung des Drehstellers (12),
- Ausgeben eines jeweiligen Raststeuersignals für jede der erfassten Rastpositionen und
- Ausgeben eines Zwischensteuersignals in Abhängigkeit von dem erfassten absoluten Drehwinkel zwischen den zumindest zwei Rastpositionen,
**gekennzeichnet durch**
- Ausgeben des Raststeuersignals unabhängig davon, ob die Sensoreinrichtung (22) eine Berührung des Drehstellers (12) erfasst,
- Ausgeben des Zwischensteuersignals nur, wenn die Sensoreinrichtung (22) eine Berührung des Drehstellers (12) erfasst und
- Erfassen der nächstliegenden der Rastpositionen anhand des erfassten absoluten Drehwinkels und Ausgeben des Raststeuersignals für die nächstliegende der Rastpositionen, falls die Sensoreinrichtung (22) keine Berührung des Drehstellers (12) erfasst.

## Claims

1. Operating apparatus (10) for a functional device of a motor vehicle, having
- a rotary actuator (12), which is mounted rotatably on a holding element (14) and has at least one coding element (16, 18),
- a detection device (20) for detecting an absolute rotation angle between the rotary actuator (12) and the holding element (14) with the aid of a coding of the at least one coding element (16, 18), and
- a latching device, by which a multiplicity of latching positions are defined for the rotary actuator (12) along a rotation direction, wherein
- the detection device (20) is configured in order to detect the respective latching position and the absolute rotation angle between at least two of the latching positions with the aid of the coding of the at least one coding element (16, 18), and
- the operating apparatus (10) comprises a sensor device (22) for detecting touching of the rotary actuator (12), and
- a control device (24), which is coupled to the detection device (20) and the sensor device (22) and emits a control signal for operation of the functional device on the basis of the detected latching position, the detected absolute rotation angle between the at least two latching positions, and/or detected touching of the rotary actuator (12), wherein
- the control device (24) emits a respective latching control signal for each of the detected latching positions, and
- the control device (24) emits at least one intermediate control signal on the basis of the detected absolute rotation angle between the at least two latching positions,
**characterised in that**
- the control device (24) emits a latching control signal irrespective of whether the sensor device (22) detects touching of the rotary actuator (12),
- the control device (24) emits an intermediate control signal only when the sensor device (22) detects touching of the rotary actuator (12), and
- the control device (24) detects the closest-lying of the latching positions with the aid of the detected absolute rotation angle, and emits the latching control signal for the closest-lying of the latching positions if the sensor device (22) does not detect touching of the rotary actuator (12).

2. Operating device (10) according to Claim 1,
**characterised in that**
the sensor device (22) comprises an optical sensor and/or a capacitive sensor.

3. Motor vehicle having an operating device (10) according to any one of the preceding claims.

4. Method for operating a functional device of a motor vehicle with an operating apparatus, wherein the operating apparatus comprises a rotary actuator (12), which is mounted rotatably on a holding element (14) and has at least one coding element (16, 18), by
- detecting an absolute rotation angle between the rotary actuator (12) and the holding element (14) with the aid of a coding of the at least one coding element (16,18),
- defining a multiplicity of latching positions along for the rotary actuator (12) its rotation direction,
- detecting the respective latching position and the absolute rotation angle between at least two of the latching positions with the aid of the coding of the at least one coding element (16, 18),
- detecting touching of the rotary actuator (12) by means of a sensor device (22),
- emitting a control signal for operation of the functional device on the basis of the detected latching position, the detected absolute rotation angle between the at least two latching positions, and/or detected touching of the rotary actuator (12),
- emitting a respective latching control signal for each of the detected latching positions, and
- emitting an intermediate control signal on the basis of the detected absolute rotation angle between the at least two latching positions,
**characterised by**
- emission of a latching control signal irrespective of whether the sensor device (22) detects touching of the rotary actuator (12),
- emission of an intermediate control signal only when the sensor device (22) detects touching of the rotary actuator (12), and
- detection of the closest-lying of the latching positions with the aid of the absolute rotation angle, and emission of the latching control signal for the closest-lying of the latching positions if the sensor device (22) does not detect touching of the rotary actuator (12).

## Revendications

1. Dispositif de commande (10) pour un appareil fonctionnel d'un véhicule automobile avec
- un actionneur rotatif (12), qui est logé de manière à pouvoir tourner sur un élément de fixation (14) et qui comporte au moins un élément de codage (16, 18),
- un dispositif de détection (20) pour détecter un angle de rotation absolu entre l'actionneur rotatif (12) et l'élément de fixation (14) à l'aide d'un codage de l'au moins un élément de codage (16, 18) et
- un dispositif à crans, par lequel une multiplicité de positions crantées est prescrite à l'actionneur rotatif (12) le long d'une direction de rotation,
- le dispositif de détection (20) étant conçu pour détecter à l'aide du codage de l'au moins un élément de codage (16, 18) la position crantée respective et l'angle de rotation absolu entre au moins deux des positions crantées, et
- le dispositif de commande (10) comprenant un dispositif capteur (22) pour détecter un contact tactile avec l'actionneur rotatif (12), et
- un dispositif de commande (24), qui est couplé au dispositif de détection (20) et au dispositif capteur (22) et qui délivre un signal de commande pour commander l'appareil fonctionnel en fonction de la position crantée détectée, de l'angle de rotation absolu détecté entre les au moins deux positions crantées et/ou d'un contact tactile détecté avec l'actionneur rotatif (12),
- le dispositif de commande (24) délivrant un signal de commande à crans respectif pour chacune des positions crantées détectées et
- le dispositif de commande (24) délivrant au moins un signal de commande intermédiaire en fonction de l'angle de rotation absolu détecté entre les au moins deux positions crantées,
**caractérisé en ce que**
- le dispositif de commande (24) délivre un signal de commande à crans indépendamment de savoir si le dispositif capteur (22) détecte un contact tactile avec l'actionneur rotatif (12),
- le dispositif de commande (24) délivre un signal de commande intermédiaire seulement si le dispositif capteur (22) détecte un contact tactile avec l'actionneur rotatif (12) et
- le dispositif de commande (24) détecte à l'aide de l'angle de rotation absolu détecté la plus proche des positions crantées et délivre le signal de commande à crans pour la plus proche des positions crantées si le dispositif capteur (22) ne détecte pas de contact tactile avec l'actionneur rotatif (12).

2. Dispositif de commande (10) selon la revendication 1, **caractérisé en ce que** le dispositif capteur (22) comprend un capteur optique et/ou un capteur capacitif.

3. Véhicule automobile avec un dispositif de commande (10) selon l'une des revendications précédentes.

4. Procédé pour commander un appareil fonctionnel d'un véhicule automobile avec un dispositif de commande, le dispositif de commande comprenant un actionneur rotatif (12), qui est logé de manière à pouvoir tourner sur un élément de fixation (14) et qui comporte au moins un élément de codage (16, 18), par
- la détection d'un angle de rotation absolu entre l'actionneur rotatif (12) et l'élément de fixation (14) à l'aide d'un codage de l'au moins un élément de codage (16, 18),
- la prescription d'une multiplicité de positions crantées pour l'actionneur rotatif (12) le long de sa direction de rotation,
- la détection de la position crantée respective et de l'angle de rotation absolu entre au moins deux des positions crantées à l'aide du codage de l'au moins un élément de codage (16, 18),
- la détection d'un contact tactile avec l'actionneur rotatif (12) au moyen d'un dispositif capteur (22),
- la délivrance d'un signal de commande pour commander l'appareil fonctionnel en fonction de la position crantée détectée, de l'angle de rotation absolu détecté entre les au moins deux positions crantées et/ou d'un contact tactile détecté avec l'actionneur rotatif (12),
- la délivrance d'un signal de commande à crans respectif pour chacune des positions crantées détectées et
- la délivrance d'un signal de commande intermédiaire en fonction de l'angle de rotation absolu détecté entre les au moins deux positions crantées,
**caractérisé par**
- la délivrance du signal de commande à crans indépendamment de savoir si le dispositif capteur (22) détecte un contact tactile avec l'actionneur rotatif (12),
- la délivrance du signal de commande intermédiaire seulement si le dispositif capteur (22) détecte un contact tactile avec l'actionneur rotatif (12) et
- la détection de la plus proche des positions crantées à l'aide de l'angle de rotation absolu détecté et la délivrance du signal de commande à crans pour la plus proche des positions crantées si le dispositif capteur (22) ne détecte pas de contact tactile avec l'actionneur rotatif (12).
